# EUROPÄISCHE PATENTANMELDUNG

(11) **EP 0 917 099 A1**
(43) Veröffentlichungstag der Anmeldung: **19.05.1999**
(21) Anmeldenummer: 98121189.9
(22) Anmeldetag: 13.11.1998
(51) Int. Cl.: G06K 19/02, G06K 19/06

(54) **Verfahren zum temporären Aufbringen von zusätzlichen Informationen auf Gegenstände mit Hilfe von Duftmitteln**

(30) Priorität: 14.11.1997 DE 19750605
(71) Anmelder: SIEMENS AKTIENGESELLSCHAFT, 80333 München (DE)
(72) Erfinder: Zorn, Dietrich, Dipl.-Ing., 82131 Gauting (DE)

(57) **Zusammenfassung**

Erfindungsgemäß wird die zusätzliche Information (i) als zumindest ein Duftmittel (DS) auf den Gegenstand (BG) aufgebracht. Die Duftmittel (DS) sind einfach auf die Gegenstände (BG) wie z.B. auf elektrische Einheiten aufzubringen und verflüchtigen ohne zusätzlichen Aufwand. Desweiteren ist das bei Bedarf detektierbare Duftmittel (DS) nicht sichtbar, wodurch ein Mißbrauch der aufgebrachten Information (i) vermieden wird. Das erfindungsgemäße Verfahren wird beispielsweise bei der Prüfung von elektrischen Baugruppen (BG) zur Kennzeichnung von fehlerhaften Baugruppen (BG) eingesetzt.

## Beschreibung

Zur Kennzeichnung bzw. Identifizierung von Gegenständen, beispielsweise von mit elektronischen Bauelementen bestückten Leiterplatten, werden häufig zusätzliche Informationen wie beispielsweise Barcodes auf die Gegenstände aufgebracht - beispielsweise auf die Leiterplatten bzw. Baugruppen aufgedruckt oder aufgestempelt. Derartige zusätzliche Informationen werden auch bei der Herstellung von Gegenständen, beispielsweise Baugruppen verwendet, um einen aktuellen Qualitätszustand des Gegenstandes bzw. der Baugruppe anzuzeigen. Bei der Herstellung einer Baugruppe wird beispielsweise eine Kennzeichnung mit Barcodes zur Anzeige einer fehlerhaften Baugruppe benutzt, wobei der Barcode nach einer Prüfung der Baugruppe aufgebracht wird. Der Barcode kann eine zusätzliche Information über die Art des Fehlers enthalten. Bei mehreren fehlerhaften Überprüfungen eines Gegenstandes, beispielsweise bei komplexen elektronischen Einheiten, werden folglich mehrere zusätzliche Informationen bzw. Barcodes auf die Gegenstände bzw. Einheiten aufgebracht.

Das Aufbringen von zusätzlichen Informationen wie Barcodes auf Gegenstände - beispielsweise elekronische Baugruppen - bedeutet einen erheblichen Aufwand, wobei die zusätzlich aufgebrachte Information insbesondere in Herstellungsprozessen meist eine temporäre Bedeutung aufweist. Diese zusätzlichen Informationen bzw. Barcodes bleiben entweder auf dem Gegenstand oder werden nach einer Behebung des festgestellten Fehlers wieder entfernt. Eine Auslieferung der Gegenstände - beispielsweies elektronische Einheiten oder Baugruppen - mit den aufgebrachten zusätzlichen Informationen kann beim Kunden zu Mißinterpretationen führen. Eine Entfernung der zusätzlichen Informationen bedeutet jedoch einen zusätzlichen Aufwand.

Die der Erfindung zugrundeliegende Aufgabe besteht darin, ein einfaches Verfahren zum temporären Aufbringen von zusätzlichen Informationen auf Gegenstände - insbesondere elektrische bzw. elektronische Einheiten - zu schaffen. Die Aufgabe wird durch die Merkmale des Patentanspruchs 1 gelöst.

Der wesentliche Aspekt des erfindugsgemäßen Verfahrens ist darin zu sehen, daß die zusätzliche Information als zumindest ein durch einen Duftmittel-Detektor detektierbares Duftmittel auf den Gegenstand aufgebracht wird. Das erfindungsgemäße Verfahren wird vorteilhaft für alle Gegenstände verwendet, die vorübergehend bzw. temporär mit zusätzlichen Informationen zu versehen sind. Das Duftmittel kann ein biologisches, ein organisches oder ein synthetisches Duftmittel sein - Anspruch 2. Als Duftmittel kommen alle biologischen, organischen und synthetischen Stoffe in Betracht, die bei Umgebungstemparatur oder aufgrund besonderer Einwirkungen auf diese Stoffe - beispielsweise Wärmeeinwirkung - exhalieren, d.h. gasförmige Stoffe abgeben.

Vorteilhaft wird das erfindungsgemäße Verfahren für das temporäre Aufbringen von zusätzlichen Informationen bei elektrischen oder elektronischen Einheiten oder Baugruppen eingesetzt - Anspruch 12, wobei das als zusätzliche Information aufgebrachte Duftmittel insbesondere bei der Herstellung von Gegenständen bzw. von elektronischen Einheiten bzw. Baugruppen vorgesehen wird - Anspruch 9. Während des Herstellungsprozesses der elektronischen Einheiten oder Baugruppen bzw. von Gegenständen repräsentiert die als Duftmittel aufgebrachte zusätzliche Information vorteilhaft eine Klassifizierungsoder eine Typen- oder eine Qualitäts- oder eine allgemeine Kennzeichnungsinformation - Anspruch 10. Eine Qualitäts-Information wird vorteilhaft nach einer Überprüfung der Gegenstände bzw. elektronischen Einheiten oder Baugruppen auf diese aufgebracht, um die Einheit bzw. Baugruppe beispielsweise als fehlerhaft zu kennzeichnen bzw. zu klassifizieren.

Die als Duftmittel aufgebrachte zusätzliche Information ist vorteilhaft auch zur Steuerung des Herstellungsprozesses eines Gegenstandes vorgesehen - Anspruch 11. Beispielsweise können durch Duftmittel spezielle weitere Herstellungsschritte wie spezielle Fehlerbeseitigungsschritte angezeigt werden.

Ein wesentlicher Vorteil des erfindungsgemäßen Verfahrens ist darin zu sehen, daß die Duftmittel einfach auf die Gegenstände wie beispielsweise auf eine elektrische Einheit aufgebracht werden können - die hierfür erforderlichen Einrichtungen sind einfach in bereits vorhandenen Einrichtungen zu integrieren - und die als Duftmittel aufgebrachte zusätzliche Information ohne zusätzlichen Aufwand von selbst verflüchtigt. Desweiteren ist das Duftmittel nicht sichtbar - kann jedoch bei Bedarf sichtbar gemacht werden -, wodurch Mißbräuche der als Duftmittel aufgebrachten zusätzlichen Information vermieden werden. Ein weiterer Vorteil besteht darin, daß mit Duftmitteln oder Duftstoffen auch sehr kleine Gegenstände wie beispielweise kleine elektronische Elemente mit zusätzlicher Information versehen werden können, um beispielsweise eine fehlende Funktion des elektronischen Elementes anzuzeigen. Ein weiterer Vorteil des erfindungsgemäßen Verfahrens besteht darin, daß kein spezieller Bereich auf den Gegenständen vorzusehen werden muß, d.h. das Duftmittel kann auf beliebige, nicht vorbereitete Oberflächen aufgebracht werden.

Erfindungsgemäß wird im Sinne einer Erkennung der zusätzlichen Information das Duftmittel mit Hilfe eines Duftmittel-Detektors bzw. Duftmittel-Sensors detektiert - Anspruch 2, wobei die Identifikations- und Detektionsdauer des zumindest einen Duftmittels durch den Duftmitteltyp und/oder dessen Intensität und/oder dessen Konzentration und/oder dessen Menge und/oder dessen Verbindungsart bestimmt ist - Anspruch 5.

Die Identifikationsdauer ist die Zeitspanne, innerhalb der ein Duftmittel identifizierbar ist, d.h. durch einen Duftmittel-Sensor bzw. Duftmittel-Detektor identifiziert bzw. detektiert werden kann - kann je nach Anwendungsfall zwischen Minuten, Tagen und in Ausnahmefällen auch Jahre betragen. Die Identifikationsdauer ist bezüglich des Duftmittels im wesentlichen von dessen Intensität und dessen 'Halbwertzeit' abhängig, wobei in die Identifikationsdauer auch die Empfindlichkeit des Duftmittel-Sensors bzw. Duftmittel-Detektors einzubeziehen ist, d.h. je empfindlicher der Duftmittel-Sensor desto länger die Identifikationsdauer.

Die Detektionsdauer repräsentiert die Zeitspanne, die für eine Detektion des jeweiligen Duftmittels erforderlich ist. Bei Herstellungsprozessen mit hohen Herstellungsgeschwindigkeiten ist beispielsweise eine kurze Detektionsdauer und damit ein Duftmittel vorzusehen, das innerhalb einer kurzen Zeitspanne detektierbar ist - beispielsweise kleiner 0,5 Minuten. Dies bedeutet, daß durch die gezielte Auswahl der Duftmittel oder Duftmittelmischungen unterschiedlichste Identifizierungs- und Detektionszeiten bestimmbar sind und damit eine Abstimmung für unterschiedlichste Einsatzfälle erreicht werden kann.

Nach einer weiteren vorteilhaften Weiterbildung des erfindungsgemäßen Verfahrens sind unterschiedliche zusätzliche Informationen durch zumindest einen Duftmitteltyp und/oder dessen Intensität und/oder dessen Konzentration und/oder dessen Menge und/oder dessen Verbindungsart definierbar - Anspruch 4. Alternativ wird bei unterschiedlichen Informationen das zumindest eine Duftmittel derart auf die Gegenstände aufgebracht, daß die Informationen kodiert sind - Anspruch 5. Auch eine Kombination von unterschiedlichen Duftmitteln in einer kodierten Form ist möglich, sofern für einen konkreten Einsatzfall eine derartige Kombination vorteilhaft erscheint.

Um insbesondere bei der Herstellung von Gegenständen zusätzliche Geruchs- und gesundheitliche Belästigungen zu vermeiden, wird vorteilhaft ein durch den menschlichen Geruchssinn nicht wahrnehmbares, nicht toxikologisches Duftmittel verwendet - Anspruch 6. Das Duftmittel bzw. der Duftstoff darf insbesondere in Fertigungsprozessen nicht störend wirken.

Gemäß einer vorteilhaften Weiterbildung des erfindungsgemäßen Verfahrens wird das zumindest eine Duftmittel derart gewählt, daß es durch einen Duftmittel-Detektor bzw. Duftmittel-Sensor einfach zu detektieren ist - Anspruch 7. Als Duftmittel-Sensoren kommen beispielsweise für Duftmittel ausgestaltete Halbleiter-Gassensoren in Betracht. Bei einem Einsatz derartiger Gassensoren wird das Duftmittel durch Einwirkung von Wärme verdampft und der aufsteigende Duftmitteldampf durch eine Halbleiterschicht geführt. Der Duftmitteldampf bewirkt elektronische Veränderungen in der Halbleiterschicht, aus denen durch elektronische Analyseverfahren das Vorhandensein und die Art des Duftmittels und damit die zusätzliche Information ermittelt wird. Desweiteren sind Sensoren nach einer chromatographischen Methode einsetzbar, bei denen das gasförmige Duftmittel in eine Flüssigkeitsschicht dringt, wodurch in einer folgenden chemischen Schicht zumindest ein chemischer Prozess eingeleitet wird. Dieser chemische Prozess wird analysiert, wodurch das Vorhandensein und die Art des Duftmittels und damit die zusätliche Information ermittelt wird. Die Sensoren nach einer chromatographischen Methode weisen aufgrund der chemischen Prozesse eine längere Detektionsdauer auf.

Im folgenden wird das erfindungsgemäße Verfahren anhand einer Zeichnung näher erläutert.

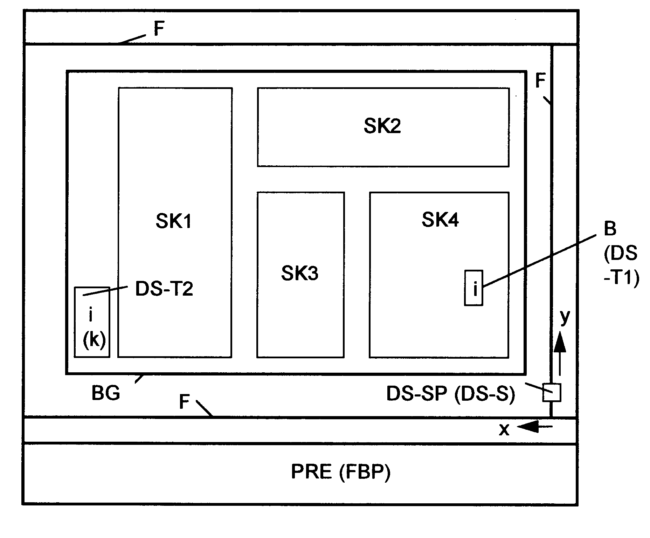

Die Zeichnung zeigt schematisch eine mit Bauelementen bestückte Baugruppe BG, die in eine Prüfeinrichtung PRE eingesetzt ist. Die Baugruppe weist beispielsweise vier Sektoren SK1..4 auf, wobei durch die in den Sektoren SK1..4 angeordneten Bauelemente jeweils eine Funktion realisiert ist. Mit Hilfe der Prüfeinrichtung werden die Funktionen der jeweiligen Sektoren SK1..4 überprüft und mit Hilfe des erfindungsgemäßen Verfahrens eine zusätzliche Information i aufgebracht.

Bei einer vollständigen Funktionsfähigkeit der Baugruppe BG wird beispielsweise ein Duftmittel bzw. ein Duftstoff DS eines ersten Typs T1 auf einen hierfür vorgesehenen Bereich der Baugruppe aufgebracht - in der Zeichnung durch ein mit DS-T2 bezeichnetes Rechteck angedeutet. Desweiteren sei für das Ausführungsbeispiel angenommen, daß der Duftstoff DS derart aufgebracht ist, daß eine kodierte Information i angezeigt wird - in der Zeichnung durch die Bezeichnung i(k) angedeutet -, wobei die kodierte Information k(i) die vollständige Funktionsfähigkeit der Baugruppe anzeigt. Die kodierte Information k(i) repräsentiert beispielsweise einen einfachen Barcode.

Für das Ausführungsbeispiel sei angenommen, daß bei der Funktionsprüfung der Baugruppe BG im vierten Sektor SK4 ein Fehler ermittelt wurde und mit großer Wahrscheinlichkeit das Bauelement B defekt ist. Erfindungsgemäß wird nun auf den vorgesehenen Bereich ein Duftmittel bzw. ein Duftstoff DS vom ersten Typ T1 derart aufgebracht, daß die Information i(k) kodiert ist, wobei die kodierte Information i(k) nun einen Fehler auf der Baugruppe BG anzeigt. Um eine anschließende Fehlersuche zu erleichtern, kann zusätzlich in kodierter Form angezeigt werden, daß der Fehler im Sektor 4 auftritt. Um die anschließende Fehlersuche an einem Fehlerbeseitigungsplatz weiter zu erleichern, kann auf das defekte Bauelement B ein Duftstoff DS eines zweiten Typs T2 aufgebracht werden, wobei der Duftstoff DS die zusätzliche Information i "Bauelement B defekt" repräsentiert. Alternativ kann der gleiche Duftstoff DS, d.h. der Duftstoff DS des ersten Tys T1 verwendet werden, da die Bereiche, auf die das Duftmittel bzw. der Duftstoff DS aufzubringen sind, unterschiedlich sind. Die Variante weist zusätzlich den Vorteil auf, daß für eine anschließende Identifizierung der Duftstoffe DS ein Duftmittel-Sensor für lediglich einen Typ T1 von Duftstoffen DS vorzusehen ist.

Für das Aufbringen der Duftstoffe DS ist ein Duftmittel-Spender DS-SP vorgesehen, der mit Hilfe von rechtwinkelig zueinander angeordneten Führungen F in X- und Y-Richtung x,y bewegbar ist und mit Hilfe von nicht dargestellen Antrieben von der Prüfeinrichtung PRE über den Bereichen positioniert wird, auf die die Duftmittel bzw. Duftstoffe DS aufzubringen sind. Der Duftstoff DS wird entweder aufgetupft oder aufgesprüht - einfache Methoden - oder durch einen Tropfen - eine präzisere Methode insbesondere hinsichtlich der aufgebrachten Menge - aufgebracht. Desweiteren kann durch den Duftmittel-Spender DS-SP eine Schutzschicht zur Erhöhung der Identifizierungsdauer hinzugefügt werden - sowohl Aufsprühen einer Schutzschicht als auch ein Bilden einer Schutzschicht um den Tropfen.

Nach dem Aufbringen der Duftstoffe DS auf die fehlerhafte Baugruppe BG wird diese an einen Fehlerbeseitigungsplatz (FBS) - nicht dargestellt - weitergeleitet. In diesem können mit Hilfe eines oder mehrerer Duftmittel-Sensoren (DS-S) die Duftstoffe bzw. Duftmittel DS identifiziert bzw. detektiert und bewertet werden. Die Positions-Steuerung der Duftmittel-Sensoren (DS-S) kann wie in der Prüfeinrichtung PRE mit Hilfe von rechtwinkelig zueinander angeordneten Führungen F erfolgen - in der Zeichnung ist dieser Zusammenhang durch in Klammern gesetzte Bezeichnungen (FBP) und (DS-S) zu den Bezeichnungen PRE und DS-SP angedeutet. Als Duftmittel-Sensoren DS-S sind beispielsweise - wie vorhergehend bereits erläuert - Halbleiter-Gassensoren oder Sensoren nach der chromatographischen Methode vorgesehen. Die Art des Duftmittel-Sensors DS-S ist auf die Art des Duftmittels DS abzustimmen, da die auf unterschiedlichen Prinzipien basierenden Duftmittel-Sensoren bzw. Duftmittel-Detektoren DS-S für unterschiedliche Duftmittelarten besonders geeignet sind.

Das erfindungsgemäße ist nicht auf das vorhergehend beschriebene Ausführungsbeispiel beschränkt, sondern ist in all den Fällen einsetzbar, bei denen ein Gegenstand temporär mit zusätzlicher Information zu versehen ist und die zusätzliche Information anschließend für eine Identifizierung oder Auswertung benutzt wird - beispielsweise Steuerung von Herstellungsprozessen oder Sortieren oder Selektieren von Gegenständen -, wobei die zusätzliche Information nicht sichtbar ist und sich nach einer einiger Zeit selbständig verflüchtigt.

## Patentansprüche

1. Verfahren zum temporären Aufbringen von zusätzlichen Informationen auf Gegenstände,
**dadurch gekennzeichnet,**
daß die zusätzliche Information (i) als zumindest ein durch einen Duftmittel-Detektor (DS-S) detektierbares Duftmittel (DS) auf den Gegenstand (BG) aufgebracht wird.

2. Verfahren nach Anspruch 1,
**dadurch gekennzeichnet,**
daß im Sinne einer Wiedergewinnung der zusätzlichen Information (i) das Duftmittel (DS) mit Hilfe eines Duftmittel-Detektors (DS-S) detektiert wird.

3. Verfahren nach Anspruch 1 oder 2,
**dadurch gekennzeichnet,**
daß das Duftmittel (DS) ein biologisches, ein organisches oder ein synthetisches Duftmittel (DS) ist.

4. Verfahren nach einem der Ansprüche 1 bis 3,
**dadurch gekennzeichnet,**
daß unterschiedliche zusätzliche Informationen (i) durch zumindest einen Duftmitteltyp (T1,2)
- und/oder dessen Intensität,
- und/oder dessen Konzentration,
- und/oder dessen Menge
- und/oder dessen Verbindungsart
definierbar ist.

5. Verfahren nach einem der Ansprüche 1 bis 4,
**dadurch gekennzeichnet,**
daß bei unterschiedlichen Informationen (i) das zumindest eine Duftmittel (DS) derart auf die Gegenstände (BG) aufgebracht wird, daß die Informationen (i(k)) kodiert sind.

6. Verfahren nach einem der Ansprüche 1 bis 5,
**dadurch gekennzeichnet,**
daß die Identifikations- und Detektionsdauer des zumindest einen Duftmittels (DS) durch den Duftmitteltyp (T1,T2) und/oder dessen Intensität und/oder dessen Konzentration und/oder dessen Menge und/oder dessen Verbindungsart bestimmt ist.

7. Verfahren nach einem der vorhergehenden Ansprüche,
**dadurch gekennzeichnet,**
daß das zumindest eine Duftmittel (DS) durch den menschlichen Geruchssinn nicht wahrnehmbar und nicht toxikologisch ist.

8. Verfahren nach einem der vorhergehenden Ansprüche,
**dadurch gekennzeichnet,**
daß das zumindest eine Duftmittel (DS) derart gewählt wird, daß es durch einen Duftmittel-Sensor (DS-S) einfach zu detektieren ist.

9. Verfahren nach einem der vorhergehenden Ansprüche,
**dadurch gekennzeichnet,**
daß das zumindest eine Duftmittel (DS) bei der Herstellung von Gegenständen (BG) auf diese aufgebracht wird.

10. Verfahren nach Anspruch 9,
**dadurch gekennzeichnet,**
daß die als Duftmittel (DS) beim Herstellungsprozess aufgebrachte zusätzliche Information (i) eine Klassifizierungs- oder eine Typen- oder eine Qualitäts- oder eine allgemeine Kennzeichnungsinformation repräsentiert.

11. Verfahren nach Anspruch 9,
**dadurch gekennzeichnet,**
daß die zusätzliche Information (i) zur Steuerung des Herstellungsprozesses eines Gegenstandes (BG) vorgesehen ist.

12. Verfahren nach einem der vorhergehenden Ansprüche,
**dadurch gekennzeichnet,**
daß die Gegenstände (BG) elektrische oder elektronische Einheiten oder Baugruppen (BG) repräsentieren.
